# EUROPÄISCHE PATENTANMELDUNG

(11) **EP 3 051 931 A1**
(43) Veröffentlichungstag der Anmeldung: **03.08.2016**
(21) Anmeldenummer: 16153258.5
(22) Anmeldetag: 29.01.2016
(51) Int. Cl.: H05K 7/14

(54) **MODULARES UMRICHTERGEHÄUSE FÜR EIN ELEKTRISCHES SCHIENENFAHRZEUG**

(30) Priorität: 29.01.2015 EP 15152991
(71) Anmelder: ABB Technology AG, 8050 Zürich (CH)
(72) Erfinder: Starz, Armin, 5417 Untersiggenthal (CH)
(74) Vertreter: ABB Patent Attorneys

(57) **Zusammenfassung**

Ein Umrichtergehäuse für ein elektrisches Schienenfahrzeug, umfassend mindestens drei Querträger (100), wobei zwei benachbarte Querträger (100) durch mindestens vier Längselemente (201) in einer Längsrichtung (900) voneinander beabstandet sind, jeder Querträger mindestens ein einstückiges, vorzugsweise gegossenes Rahmenelement (110) umfasst, welches ein erstes Strebenelement (11) umfasst, welches in einer ersten Richtung senkrecht zur Längsrichtung verläuft, sowie ein zweites Strebenelement (112) umfasst, welches vorzugsweise in der ersten Richtung (901) senkrecht zur Längsrichtung verläuft wobei das erste und das zweite Strebenelement durch ein drittes (113) und ein viertes (114) Strebenelement in einer zweiten Richtung (902) senkrecht zur Längsrichtung voneinander beabstandet sind.

## Beschreibung

### TECHNISCHES GEBIET

Die Erfindung bezieht sich auf das Gebiet der elektrischen Energieversorgung von Schienenfahrzeugen. Sie betrifft ein Umrichtergehäuse für ein elektrisches Schienenfahrzeug nach dem Oberbegriff des unabhängigen Patentanspruchs, insbesondere für die Unterflur- oder Überflurmontage.

### TECHNOLOGISCHER HINTERGRUND

Traktionsumrichter für elektrische Schienenfahrzeuge, insbesondere sogenannte Bahnstromrichter, werden je nach Kundenanforderung und Zugtyp an verschiedenen Orten installiert. Somit können derartige Umrichter insbesondere in einem Wagenkasten, auf bzw. unter dem Wagenkasten oder in einer Lok wiedergefunden werden. Hierbei können wiederum bei individuellen Designs und Zusammenbauten unterschiedlichste Einbausituationen entstehen, welche Flexibilität bei einem Umrichterdesign erfordern.

Besonders hohe Anforderungen sind dabei an Umrichtergehäuse zu stellen, bei welchen eine Anbringung oder Montage ausserhalb des Wagenkastens vorgesehen ist, insbesondere an Umrichtergehäuse zur sogenannten Unterflurmontage, d.h. zur Anbringung unterhalb des Wagenkastens. Solche Umrichtergehäuse müssen einerseits eine hinreichende mechanische Stabilität gewährleisten, um eine stabile und sichere Montage des Umrichters am Schienenfahrzeug zu erlauben und zu gewährleisten, dass ein Gesamtsystem aus Umrichtergehäuse und Umrichter in montiertem Zustand eine hinreichende Vibrationsfestigkeit aufweist. Andererseits dürfen sie auch keine zu grosse mechanische Festigkeit, insbesondere Steifigkeit, aufweisen, da es sonst bei einem Fahrbetrieb zu unerwünscht hohen mechanischen Belastungen des Umrichtergehäuses und dessen Befestigungen kommt; und/oder eine gewünschte Beweglichkeit, insbesondere eine Torsions- und/oder Scherelastizität desjenigen Zugsegments (im Allgemeinen eines Abteils), an welchem das Umrichtergehäuse angebracht ist, in unerwünschtem Ausmass reduziert wird, was im Allgemeinen einen negativen Einfluss auf die Strukturmechanik des gesamten Wagenkastens hat und die Fahreigenschaften in unerwünschter Weise beeinflusst.

Andererseits müssen Umrichtergehäuse zur Anbringung ausserhalb des Wagenkastens hohe Anforderungen im Hinblick auf eine Feuchtigkeits-, Wasser- und Staubdichtigkeit erfüllen; Umrichtergehäuse für die Unterflurmontage zudem häufig steinschlagfest sein.

Unter anderem aus den oben genannten Gründen wurden Umrichtergehäuse zur Anbringung ausserhalb des Wagenkastens bis anhin üblicherweise zumindest vorwiegend geschweisst, wobei im Allgemeinen aus Profilen, welche vorzugsweise aus Aluminium gefertigt sind, zunächst ein Gehäusegerüst oder Tragrahmen gefertigt wurde, auf welches anschliessend seitlich sowie oben und unten Abdeckplatten vorzugsweise geschweisst, teilweise genietet oder geschraubt wurden.

Bis dato wurden für neue Projekte zur Unterbringung des oder der Traktionsumrichter entweder komplett neue Umrichtergehäuse entwickelt, oder bereits vorhandene Gehäusedesigns angepasst. Dies ist durch den Zusammenbau des Umrichters oder den Platzverhältnissen bzw. allg. mechanischen Randbedingungen bedingt.

Eine derartige Neuentwicklung bedarf jedoch eines hohen Aufwands an Ressourcen und Entwicklungszeit, was bei den üblichen Liefersituationen eine grosse Herausforderung darstellen kann. Verschiedenste Arbeiten wie die Gehäusekonstruktion selbst, der Entscheid für eine Fertigungstechnologie, FEM-Berechnungen und verschiedenste Baugruppenausarbeitungen müssen bewältigt werden. Der Aufwand, welcher benötigt wird, um vorhandene Gehäusedesigns anzupassen, reduziert einen Gesamtaufwand oft nur geringfügig, da auch kleine Änderungen grossen Einfluss auf die oben genannten Aspekte haben können. Des Weiteren werden Detailprobleme wie beispielsweise die Verbindungstechnik, Dichtungstechnik, Verbindungselemente, allg. Struktur im Gehäuse, interne und externe Kühlung usw. oft neu entwickelt, was wiederum umfangreiche Entwicklungszeit und Ressourcen in Anspruch nimmt.

Bei Umrichtergehäusen mit geschweisstem Gehäusegerüst ergibt sich zudem ab einer gewissen Grösse, insbesondere Länge, das Problem, dass gewünschte Fertigungstoleranzen nur mit sehr grossem Aufwand oder sogar praktisch gar nicht erreicht werden können. Dies bedingt dann entweder eine Aufteilung des Umrichters in mehrere Untereinheiten, was wiederum elektrisch anspruchsvoll und deswegen im Allgemeinen mit hohen Mehrkosten verbunden ist; oder es muss einen Befestigungstechnologie gewählt werden, welche mit erhöhten Fertigungsungenauigkeiten zurechtkommen kann, was wiederum aufwendig, anspruchsvoll und teuer ist.

Es ist deswegen Aufgabe der Erfindung, ein Umrichtergehäuse anzugeben, mittels welchem die vorstehend beschriebenen Nachteile vermieden werden können.

### BESCHREIBUNG DER ERFINDUNG

Diese und weitere Aufgaben werden durch ein Umrichtergehäuse mit den Merkmalen des unabhängigen Patentanspruchs gelöst. Weitere vorteilhafte Ausgestaltungen der Erfindung sind in den abhängigen Patentansprüchen angegeben.

Ein erfindungsgemässes Umrichtergehäuse für ein elektrisches Schienenfahrzeug, umfasst
mindestens drei Querträger, wobei
zwei benachbarte Querträger, insbesondere jeweils zwei benachbarte Querträger, durch mindestens vier Längselemente in einer Längsrichtung voneinander beabstandet sind,
jeder Querträger mindestens ein einstückiges, vorzugsweise gegossenes Rahmenelement umfasst, welches
ein erstes Strebenelement umfasst, welches in einer ersten Richtung senkrecht zur Längsrichtung verläuft, sowie
ein zweites Strebenelement umfasst, welches vorzugsweise in der ersten Richtung senkrecht zur Längsrichtung verläuft
wobei das erste und das zweite Strebenelement durch
ein drittes und ein viertes Strebenelement in einer zweiten Richtung senkrecht zur Längsrichtung voneinander beabstandet sind.

Das erfindungsgemässe Umrichtergehäuse basiert auf einem modularen Design, und kann somit ohne nennenswerten Designaufwand verschiedenen Anbausituationen bzw. Montageorten angepasst werden, insbesondere entsprechend unterschiedlichen Platzverhältnissen an unterschiedlichen Zugsegmenten eines Zuges; aber auch an unterschiedlichen Triebwagen, Schienenfahrzeugen oder Zügen. So kann insbesondere eine Anzahl der Querträger und/oder eine Länge der mit diesen verbundenen Längselemente variiert werden, um eine Gesamtlänge des Umrichtergehäuses anzupassen bzw. zu definieren. Die Anpassung der Gesamtlänge erfordert somit keine Anpassung eines Designs, insbesondere einer Form, der Querträger, was eine kostengünstige Herstellung und rasche Anpassbarkeit erfindungsgemässer Umrichtergehäuse erlaubt.

In einer bevorzugten Weiterbildung des erfindungsgemässen Umrichtergehäuses sind dabei sämtliche Querträger identisch ausgeführt, was Herstellungsaufwand und -kosten nochmals reduziert.

In einer weiteren bevorzugten Weiterbildung des erfindungsgemässen Umrichtergehäuses umfasst jeder Querträger zwei einstückige, vorzugsweise gegossene, Rahmenelemente, welche in der ersten Richtung senkrecht zur Längsrichtung, mittels eines ersten Querelements (121) und eines zweiten Querelements (122), vorzugsweise in Form jeweils eines Strangpressprofils, miteinander verbunden und zueinander beabstandet sind. Das erste und das zweite Querelement sind dabei vorzugsweise nicht einstückig mit dem Rahmenelement gebildet, sondern vorzugsweise verschraubt, vernietet oder anderweitig lösbar verbunden, beispielsweise mittels Formschluss. Insbesondere sind Rahmenelement und Querelemente vorzugsweise nicht miteinander vergossen, verschweisst, oder verlötet. Auf diese Weise wird es ermöglicht, auf unkomplizierte Weise eine Gesamtbreite des Umrichtergehäuses anzupassen bzw. zu definieren, ohne ein Design, insbesondere eine Form, der Rahmenelemente anpassen zu müssen. Es muss lediglich eine Ausdehnung der Querelemente in der ersten Richtung senkrecht zur Längsrichtung vorgenommen werden, um die Gesamtbreite in weiten Bereichen variieren zu können. Insbesondere für den Fall, dass Querelemente in Form von Strangpressprofilen vorgesehen sind, ist eine äusserst einfache Breitenanpassung möglich.

In einer bevorzugten Weiterbildung des erfindungsgemässen Umrichtergehäuses sind Querträger und Längselemente ebenfalls nicht einstückig gebildet. Vielmehr ist jedes Längselemente mit zwei benachbarten Querträgern vorzugsweise verschraubt, vernietet oder anderweitig lösbar verbunden, beispielsweise mittels Formschluss. Insbesondere sind Querträger und Längselemente vorzugsweise nicht miteinander vergossen, verschweisst, oder verlötet.

Vorzugsweise sind an den Querträgern Knotenpunkte vorgesehen, an welchen mindestens eine, vorzugsweise eine Vielzahl von Schnittstellen integriert ist, welche eine Verbindung mit den Längselementen erlauben, insbesondere mittels Auf- oder Anstecken, Anschrauben und/oder Annieten von Längselementen.

Vorzugsweise sind die Knotenpunkte dabei an von den Querträgern umfassten Rahmenelementen vorgesehen, insbesondere einstückig an diesen angeformt, so dass die Knotenpunkte eine Verbindung mit den Querelementen erlauben, insbesondere mittels Auf- oder Anstecken, Anschrauben und/oder Annieten von Querelementen.

Die Schnittstellen an den Knotenpunkten umfassen dabei vorzugsweise ein oder mehrere geeignete Befestigungspunkte und/oder Befestigungselemente, welche ein Auf- oder Anstecken, Anschrauben und/oder Annieten von Längselementen und/oder Querelementen erlauben.

Vorzugsweise umfassen die Knotenpunkte ein oder mehrere erste Zapfenelemente, welche sich zumindest im Wesentlichen in Längsrichtung erstrecken, und an welchen die Schnittstellen ausgebildet sind. Eine Ausdehnung *l* der ersten Zapfenelemente in Längsrichtung ist dabei wesentlich kleiner als ein Abstand *L* zum benachbarten Querträger, wobei insbesondere 10*l* < *L,* vorzugsweise 50*l* < *L* gilt.

Ferner umfassen ein oder mehrere Knotenpunkte vorzugsweise mindestens ein zweites Zapfenelement, welches sich zumindest im Wesentlichen in Querrichtung erstreckt, und an welchem mindestens eine Schnittstelle ausgebildet sind. Eine Ausdehnung *l*₂ des zweiten Zapfenelements in Querrichtung ist dabei wesentlich kleiner als ein Abstand *L* zum benachbarten Querträger, wobei insbesondere 10*l*₂ < *L,* vorzugsweise 50*l*₂ < *L* gilt.

Die Rahmenelemente eines jeden Querträgers sind dabei vorzugsweise zumindest im Wesentlichen identisch ausgeführt, um Herstellungsaufwand und -kosten weiter minimieren zu können. Vorteilhaft können aber auch ein in Längsrichtung zuvorderst und/oder ein in Längsrichtung zuhinterst angeordneter Querträger Unterscheide zu den restlichen Querträgern aufweisen, wobei vorzugsweise der in Längsrichtung zuvorderst angeordnete Querträger wiederum zumindest im Wesentlichen identisch mit zu dem in Längsrichtung zuhinterst angeordneten Querträger ausgeführt ist.

In einer weiteren bevorzugten Weiterbildung des erfindungsgemässen Umrichtergehäuses sind die Längselemente aus Blech ausgeführt, vorzugsweise gestanzt. Wie sich gezeigt hat, kann so eine gewünschte Torsions- oder Scherelastizität des Umrichtergehäuses insbesondere in Längsrichtung erreicht werden, ohne dass weitere besondere Massnahmen erforderlich wären. Vorzugsweise sind dabei sich in der zweiten Richtung senkrecht zur Längsrichtung gegenüberliegende Längselemente als einstückiger Längsträgerrahmen ausgeführt, welcher mittels Stanzens und Biegens aus Blech herstellbar ist.

Eine strukturmechanische Besonderheit des vorstehend beschriebenen, erfindungsgemässen Umrichtergehäuses ist zudem, dass dieses je nach Anforderung in sich tragend oder flexibel bzw. elastisch, ausgelegt werden kann.

Ein in sich tragend ausgelegtes Umrichtergehäuse stellt dabei in einem Gesamtzusammenbau des Schienenfahrzeugs ein starres Konstrukt dar.

Ein flexibel ausgelegtes Gehäuse wiederum ist nicht steif und kann sich somit bei möglichen Torsionsbelastungen des Schienenfahrzeugs elastisch mitbewegen. Diese Möglichkeit wird mit zunehmender Gehäusegrösse interessant, da das Umrichtergehäuse sonst erheblichen und meist negativen Einfluss auf die Strukturmechanik des gesamten Schienenfahrzeugs nimmt und die Fahreigenschaften ändert.

### KURZE BESCHREIBUNG DER FIGUREN

Es zeigen schematisch
Fig. 1 ein bevorzugtes Ausführungsbeispiel eines erfindungsgemässen Umrichtergehäuses;
Fig. 2 einen Querträger für das Umrichtergehäuse aus Fig. 1;
Fig. 3 ein Segment des Umrichtergehäuses aus Fig. 1 in Explosionszeichnung;
Fig. 4 einen vergrösserten Ausschnitt aus Fig. 1;
Fig. 5 eine Aufsicht auf einen in einer Längsrichtung zuvorderst angeordneten Querträger des Umrichtergehäuses aus Fig. 1;
Fig. 6 eine Oberseite eines exemplarischen Segments des Umrichtergehäuses aus Fig. 1;
Fig. 7 eine Unterseite eines exemplarischen Segments des Umrichtergehäuses aus Fig. 1.

Grundsätzlich bezeichnen gleiche Bezugszeichen gleiche Teile.

### WEGE ZUR AUSFÜHRUNG DER ERFINDUNG

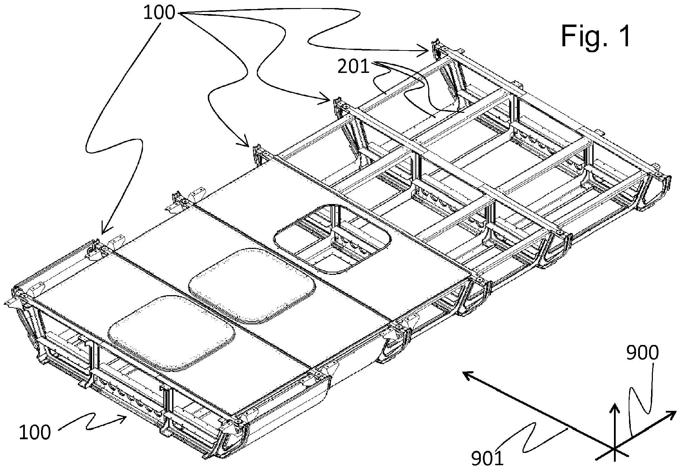

Fig. 1 zeigt ein bevorzugtes Ausführungsbeispiel eines erfindungsgemässen Umrichtergehäuses in schematischer Darstellung.

Das Umrichtergehäuse umfasst sechs Querträger 100, welche entlang einer Längsrichtung 900 paarweise zueinander beabstandet angeordnet sind, wobei sich zwischen zwei benachbarten Querträgern 100 jeweils acht Längselemente 201 erstrecken, welche besagte Querträger miteinander verbinden. Längselemente und Querträger sind dabei vorzugsweise mittels Steckverbindungen miteinander verbunden und vernietet, so dass eine formschlüssige Verbindung besteht. Querträger 100 und Längselemente 201 bilden einen Gehäuserahmen, welcher eine Grundstruktur des Umrichtergehäuses definiert. In Längsrichtung 900 zuvorderst bzw. zuhinterst angeordnete Querträger 100 sind dabei sowohl untereinander als auch zu den dazwischen angeordneten Querträgern 100 identisch.

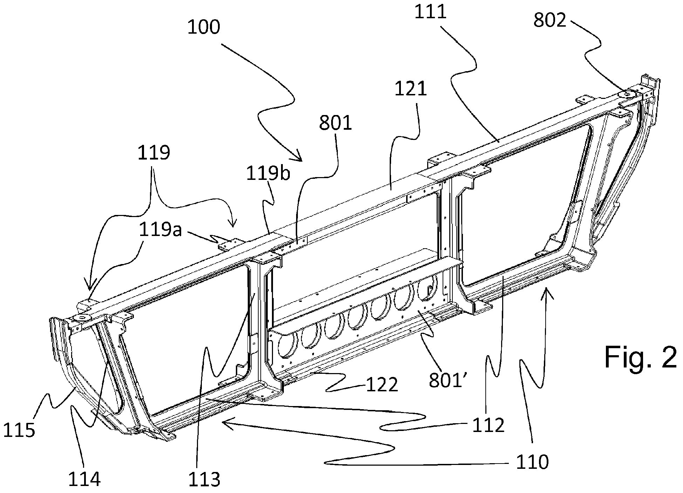

Fig. 2 zeigt einen Querträger 100 für das Umrichtergehäuse aus Fig. 1. Der Querträger 100 umfasst zwei identische, einstückige, gegossene Rahmenelemente 110. Jedes Rahmenelement 110 umfasst ein erstes Strebenelement 111 sowie ein zweites Strebenelement 112, welche parallel zueinander in einer ersten Richtung 901 senkrecht zur Längsrichtung verlaufen. Zwischen erstem Strebenelement 111 und zweitem Strebenelement 112, welche in einer zweiten Richtung 902 senkrecht zur Längsrichtung und senkrecht zur ersten Richtung 901 relativ zueinander beabstandet sind, sind jeweils dritte, vierte und fünfte Strebenelemente 113, 114, 115 ausgebildet, welche paarweise zueinander in der ersten Richtung 901 beabstandet sind.

Die beiden Rahmenelemente 110 sind über ein erstes Querelement 121 und ein zweites Querelement 122 miteinander verbunden und in der ersten Richtung 901 senkrecht zur Längsrichtung zueinander beabstandet, wobei jedes der Rahmenelemente 110 jeweils formschlüssig mit jedem Querelement verbunden ist. Zur Erreichung oder Erhöhung einer Verbindungsfestigkeit sind Verbindungsbleche 801, 801' vorgesehen, welche sowohl mit den Rahmenelementen als auch mit den Querelementen vernietet, gegebenenfalls zusätzlich oder alternativ verschweisst und/oder verschraubt sind. Die Verbindungsbleche können dabei als reine Verbindungsbleche 801 ausgeführt sein, vorzugsweise aber auch als funktionale Verbindungsbleche 801' neben der Verbindung bzw. der Erhöhung deren Festigkeit noch weitere Funktionen aufweisen, so z.B. insbesondere als Auflage und/oder Durchführung dienen. Die Querelemente sind vorteilhaft als Strangpressprofile ausgeführt.

An den ersten Strebenelementen 111 jedes Rahmenelements 110 ist zwischen dem vierten Strebenelementen 114 und fünften Strebenelement 115 ein Befestigungselement 802 vorgesehen, welches eine Bohrung umfasst, mittels welcher das Umrichtergehäuse an einer Unterseite eines Schienenfahrzeugs befestigt, vorzugsweise angeschraubt werden kann. Dabei dienen Befestigungselement 802 und/oder ein Bereich der ersten Strebenelemente 111 zwischen dem vierten Strebenelementen 114 und fünften Strebenelement 115 als Auflagefläche am Schienenfahrzeug. Dadurch wird, insbesondere bei einer Unterflurmontage, ein optimaler Kraftfluss zwischen Befestigungselement 802 und den Strebenelementen gewährleistet. Vorteilhaft kann zwischen Befestigungselement 802 und dem Schienenfahrzeug auch ein Adapterelement 810 zum Zwecke der Befestigung vorgesehen sein.

Schnittpunkte des ersten oder zweiten Strebenelements mit dem dritten oder vierten Strebenelement sind jeweils als Knotenpunkte 119 ausgeführt, welche erste Zapfenelemente 119a und vorzugsweise zweite Zapfenelemente 119b aufweisen, an welchen eine Vielzahl von Schnittstellen integriert ist, insbesondere zum Auf- oder Anstecken von Längselementen 201, vorzugsweise in Längsrichtung 900 beiderseits des Querträgers 100.

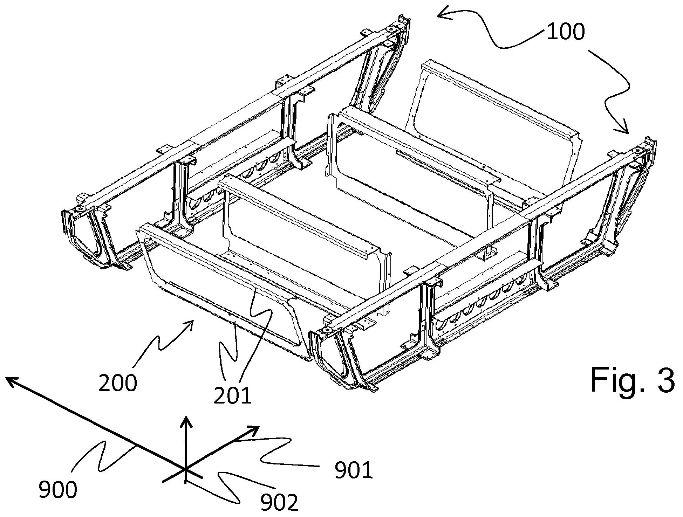

Fig. 3 zeigt ein exemplarisches Segment des Umrichtergehäuses aus Fig. 1 in Explosionszeichnung. Wie ersichtlich ist, sind vorzugsweise jeweils zwei sich in der zweiten Richtung 902 senkrecht zur Längsrichtung gegenüberliegende Längselemente 201 als Teil eines einstückigen Längsträgerrahmens 200 ausgeführt, der vorzugsweise mittels Stanzens und Biegens aus Blech gefertigt ist. Dies erlaubt eine einfache und kostengünstige Herstellung der Längselemente 201. Zudem reduziert sich so eine Gesamtzahl an Bauteilen, die für einen Zusammenbau des Umrichtergehäuses erforderlich sind.

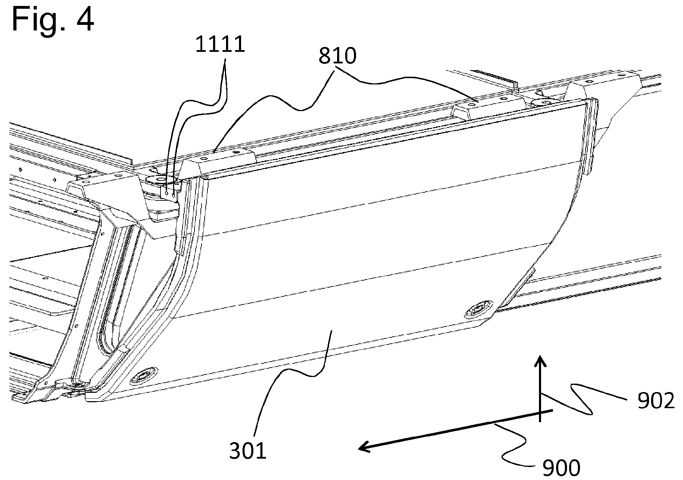

Der Bereich der ersten Strebenelemente 111 zwischen dem vierten Strebenelementen 114 und fünften Strebenelement 115 dient vorzugsweise ferner zur Anbringung eines klappbaren Seitendeckels, insbesondere in Form einer Wagenkastenschürze 301, wozu vorzugsweise Befestigungspunkte 1111 an den ersten Strebenelementen 111 vorgesehen sind, zwischen welchen eine sich in Längsrichtung 900 erstreckende Wagenkastenschürzen-Aufhängung vorgesehen ist, an welcher wiederum die Wagenkastenschürze aufgehängt ist bzw. aufgehängt werden kann, wie in Fig. 4 dargestellt ist, welche einen vergrösserten Ausschnitt aus Fig. 1 zeigt.

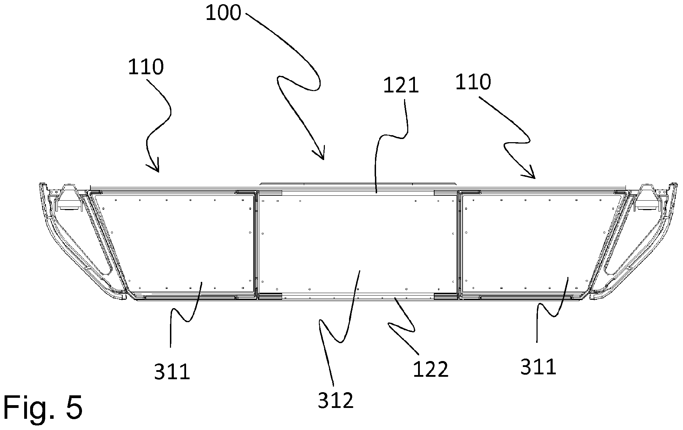

Einzelne, mehrere oder alle Strebenelemente eines oder mehrere Querträger weisen vorzugsweise Schnittstellen für eine Montage von Baugruppen innerhalb des Umrichtergehäuses, und/oder für eine Anbringung von Gehäuse-Wandteilen auf. Fig. 5 zeigt eine Aufsicht auf den in Längsrichtung 900 zuvorderst angeordneten Querträger 100. Im Bereich der Rahmenelemente 110 sind erste Abschlussdeckel 311 mittels Nietverbindungen an den Strebenelementen angebracht. In einem Bereich zwischen den beiden Rahmenelementen 110 und den Querelementen 121, 122 ist ein zweiter Abschlussdeckel 312 ebenfalls mittels Nietverbindungen angebracht.

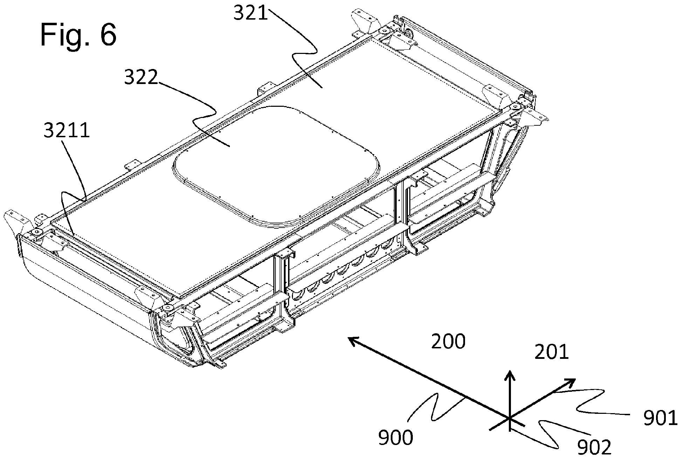

Fig. 6 zeigt eine Oberseite eines exemplarischen Segments des Umrichtergehäuses aus Fig. 1. Zwischen zwei benachbarten Querträgern 100 ist jeweils eine oberseitige Gehäuseabdeckung in Form eines Dach-Mantelblechs 321 angebracht, welches mit den ersten Strebenelementen 111 und den ersten Querelementen 121 der Querträger 100 sowie den zwei in der ersten Richtung 901 senkrecht zur Längsrichtung zuäusserst gelegenen, oberen Längselementen 201 des Segments abgedichtet, vorzugsweise abgedichtet nach IP6X, verbunden ist.

In einer bevorzugten Ausgestaltung ist die oberseitige Gehäuseabdeckung mit dem Gehäuserahmen, vorzugsweise mit Elementen des Gehäuserahmens wie vorstehend beschrieben, verklebt, vorzugsweise mittels einer elastischen Verklebung. Dazu ist vorzugsweise in einem Randbereich 3211 des Dach-Mantelblechs 321 (wie in Fig. 6 durch eine gestrichelte Linie gekennzeichnet), eine umlaufende, geschlossene Klebnaht zwischen Dach-Mantelblech 321 und Gehäuserahmen gebildet. Wie sich überraschend herausgestellt hat, ermöglich eine verklebte oberseitige Gehäuseabdeckung eine besonders flexible Auslegung des Umrichtergehäuses, insbesondere in Verbindung mit Längselementen aus - vorzugsweise gestanztem - Blech. Somit kann eine besonders hohe Scher- und Torsionselastizität erreicht werden, was sich positiv auf das Fahrverhalten von Schienenfahrzeugen auswirken kann, an welchen das Umrichtergehäuse montiert ist.

In der oberseitigen Gehäuseabdeckung ist vorteilhaft eine erste Zugangs- oder Wartungsöffnung vorgesehen, welche vorzugsweise mittels einer abnehmbaren Dach-Abdeckung 322 oder einer schwenkbaren Luke - vorzugsweise gemäss IP6X abgedichtet - verschliessbar ist.

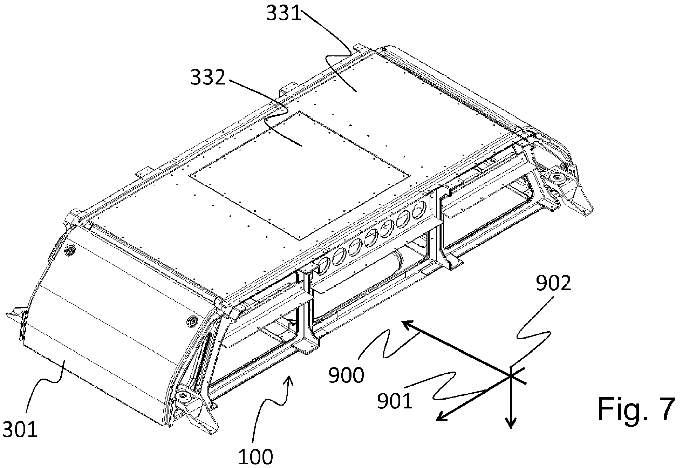

Fig. 7 zeigt eine Unterseite eines exemplarischen Segments des Umrichtergehäuses aus Fig. 1. Zwischen zwei benachbarten Querträgern 100 ist jeweils eine unterseitige Gehäuseabdeckung in Form eines Boden-Mantelblechs 331 angebracht, welches mit den zweiten Strebenelementen 112 und den zweiten Querelementen 122 der Querträger 100 sowie zwei in der ersten Richtung 901 senkrecht zur Längsrichtung zuäusserst gelegenen, unteren Längselementen 201 des Segments abgedichtet, vorzugsweise abgedichtet nach IP6X, verbunden ist.

In einer bevorzugten Ausgestaltung ist die unterseitige Gehäuseabdeckung mit dem Gehäuserahmen, vorzugsweise mit Elementen des Gehäuserahmens wie vorstehend beschrieben, vernietet oder verschraubt.

Das Boden-Mantelblech 331 ist vorzugsweise seitlich abgebogen, wobei ein abgebogener Teil in einer Nut versenkt ist, um keinerlei Angriffsfläche für Steinschlag oder ähnliches zu bieten.

In der unterseitigen Gehäuseabdeckung ist vorteilhaft ebenfalls eine Zugangs- oder Wartungsöffnung vorgesehen, welche vorzugsweise mittels einer abnehmbaren Boden-Abdeckung 332 oder einer schwenkbaren Luke - vorzugsweise gemäss IP6X abgedichtet - verschliessbar ist. Boden-Abdeckung 332 oder Luke sind vorzugsweise in dem Boden-Mantelblech 331 entsprechender Weise seitlich abgebogen und versenkt.

Auch wenn die Erfindung vorstehend mit Bezug auf spezifische Ausführungsformen beschrieben und veranschaulicht ist, ist diese nicht auf diese Ausführungsformen beschränkt. Vielmehr können innerhalb des Schutz- und Äquivalenzbereichs der Patentansprüche verschiedene Modifikationen von Einzelheiten vorgenommen werden, ohne dass daraus eine Abweichung von der Erfindung resultiert.

Insbesondere schliessen die Angaben "umfasst" und "umfassend" ein Vorhandensein weiterer Merkmale oder zusätzlicher Verfahrensschritte nicht aus. Ferner ist die Angabe "ein" oder "eine" im Zweifelsfall nicht als Mengenangabe, sondern als unbestimmter Artikel zu verstehen, und schliesst eine Mehrzahl, insbesondere ein doppeltes oder mehrfaches Vorhandensein eines Merkmals oder Verfahrensschrittes, auf welches bzw. welchen die Angabe bezogen ist, nicht aus. Ein Ausschluss einer Mehrzahl wird auch nicht dadurch impliziert, dass hinsichtlich anderer Merkmale oder Verfahrensschritte explizit eine Mehrzahl beschrieben ist.

### BEZUGSZEICHENLISTE

- 1: Gehäuse
- 100: Querträger
- 110: Rahmenelement
- 111: erstes Strebenelement
- 112: zweites Strebenelement
- 113: drittes Strebenelement
- 114: viertes Strebenelement
- 115: fünftes Strebenelement
- 119: Knotenpunkt
- 119a: erstes Zapfenelement
- 119b: zweites Zapfenelement
- 121: erstes Querelement
- 122: zweites Querelement
- 200: Längsträgerrahmen
- 201: Längselement
- 301: Wagenkastenschürze
- 311: erster Abschlussdeckel
- 312: zweiter Abschlussdeckel
- 321: Dach-Mantelblech
- 322: Dach-Abdeckung
- 331: Boden-Mantelblech
- 332: Boden-Abdeckung
- 801, 801': Verbindungsblech
- 802: Befestigungselement
- 810: Adapterelement
- 900: Längsrichtung
- 901: erste Richtung senkrecht zur Längsrichtung
- 902: zweite Richtung senkrecht zur Längsrichtung
- 1111: Befestigungspunkte
- 3211: Randbereich des Dach-Mantelblechs

## Patentansprüche

1. Umrichtergehäuse für ein elektrisches Schienenfahrzeug, umfassend
a) mindestens drei Querträger (100), wobei
b) zwei benachbarte Querträger durch mindestens vier Längselemente (201) in einer Längsrichtung (900) voneinander beabstandet sind,
c) jeder Querträger ein einstückiges, vorzugsweise gegossenes Rahmenelement (110) umfasst, welches
d) ein erstes Strebenelement (111) umfasst, welches in einer ersten Richtung senkrecht zur Längsrichtung verläuft, sowie
e) ein zweites Strebenelement (112) umfasst, welches vorzugsweise in der ersten Richtung (901) senkrecht zur Längsrichtung verläuft
f) wobei das erste und das zweite Strebenelement durch
g) ein drittes Strebenelement (113) und ein viertes Strebenelement (114) in einer zweiten Richtung (902) senkrecht zur Längsrichtung voneinander beabstandet sind.

2. Umrichtergehäuse nach Anspruch 1, **dadurch gekennzeichnet dass** das Umrichtergehäuse mindestens zwei, vorzugsweise mindestens vier, identische Querträger (100) einer ersten Art umfasst.

3. Umrichtergehäuse nach Anspruch 2, **dadurch gekennzeichnet dass** das Umrichtergehäuse mindestens zwei identische Querträger einer zweiten Art umfasst.

4. Umrichtergehäuse nach einem der vorangehenden Ansprüche, **dadurch gekennzeichnet dass** jeder Querträger zwei einstückige, insbesondere gegossene, vorzugsweise zumindest im Wesentlichen identische, Rahmenelemente (110) umfasst, welche in der ersten Richtung senkrecht zur Längsrichtung, mittels eines ersten Querelements (121) und eines zweiten Querelements (122), vorzugsweise in Form jeweils eines Strangpressprofils, zueinander beabstandet sind.

5. Umrichtergehäuse nach einem der vorangehenden Ansprüche, **dadurch gekennzeichnet, dass** jedes Rahmenelement (110) ein fünftes Strebenelement (115) umfasst, welches zwischen dem ersten und dem zweiten Strebenelement verläuft.

6. Umrichtergehäuse nach einem der vorangehenden Ansprüche, **dadurch gekennzeichnet, dass** das erste und zweite Strebenelement mit dem dritten bzw. vierten Strebenelement jeweils an einem von vier Knotenpunkten (119) verbunden ist, wobei an den Knotenpunkten Befestigungselemente zur formschlüssigen Verbindung mit jeweils mindestens einem Längselement (201) vorgesehen sind.

7. Umrichtergehäuse nach einem der vorangehenden Ansprüche, **dadurch gekennzeichnet dass** mindestens zwei, vorzugsweise sich in der zweiten Richtung senkrecht zur Längsrichtung, gegenüberliegende Längselemente (201) als einstückiger Längsträgerrahmen (200) ausgeführt sind.

8. Umrichtergehäuse nach einem der Ansprüche 4 bis 7, **dadurch gekennzeichnet dass** zwischen zwei benachbarten Querträgern (100) eine unterseitige Gehäuseabdeckung, insbesondere ein Boden-Mantelblech (331), angebracht ist, welches mit den zweiten Strebenelementen der Querträger (100), den zweiten Querelementen und zwei Längselementen abgedichtet, vorzugsweise nach IP6X, verbunden, vorzugsweise vernietet oder verschraubt, ist.

9. Umrichtergehäuse nach einem der Ansprüche 4 bis 8, **dadurch gekennzeichnet dass** zwischen zwei benachbarten Querträgern eine oberseitige Gehäuseabdeckung angebracht ist, welche mit den ersten Strebenelementen (111) der Querträger, den ersten Querelementen (121) und zwei Längselementen (201) abgedichtet, vorzugsweise abgedichtet nach IP6X, verbunden, vorzugsweise verklebt, ist.

10. Umrichtergehäuse nach einem der Ansprüche 5 bis 9, **dadurch gekennzeichnet, dass** an zwei aufeinanderfolgenden fünften Strebenelementen ein klappbarer Seitendeckel, insbesondere eine Wagenkastenschürze (301), angebracht ist; und/oder an einem in Längsrichtung zuvorderst und an einem in Längsrichtung zuhinterst angeordneten Querträger je ein oder mehrere Abschlussdeckel (311, 312) abgedichtet, vorzugsweise abgedichtet nach IP6X, angebracht sind.

11. Umrichtergehäuse nach einem der vorangehenden Ansprüche, **dadurch gekennzeichnet dass** eine Vielzahl von Rahmenelementen jeweils mehrere Knotenpunkte (119) umfasst, welche Knotenpunkte einstückig am Rahmenelement angeformt sind, wobei an mindestens einem Knotenpunkt ein oder mehrere Längselemente befestigt sind.

12. Umrichtergehäuse nach einem der vorangehenden Ansprüche, **dadurch gekennzeichnet dass** Querträger und Längselemente nicht miteinander verschweisst, verlötet oder vergossen sind; und/oder Rahmenelemente und Querelemente nicht miteinander verschweisst, verlötet oder vergossen sind.

13. Umrichtergehäuse nach einem der vorangehenden Ansprüche, **dadurch gekennzeichnet dass** Querträger und Längselemente nicht einstückig ausgeführt sind; und/oder Rahmenelemente und Querelemente nicht einstückig ausgeführt sind.

14. Traktionsumrichter für ein elektrisches Schienenfahrzeug, **dadurch gekennzeichnet, dass** der Traktionsumrichter in einem Umrichtergehäuse nach einem der Ansprüche 1 bis 11 untergebracht ist.

15. Elektrisches Schienenfahrzeug mit einem Trakionsumrichter, **dadurch gekennzeichnet, dass** der Traktionsumrichter in einem Umrichtergehäuse nach einem der Ansprüche 1 bis 11 untergebracht ist, welches auf einem Dach oder unter einem Unterboden des Schienenfahrzeugs montiert ist.
